# EUROPEAN PATENT SPECIFICATION

(11) **EP 0 493 044 B1**
(45) Date of publication and mention of the grant of the patent: **07.02.1996**
(21) Application number: 91311908.7
(22) Date of filing: 20.12.1991
(51) Int. Cl.: H03M 7/14, H03M 7/20, H03M 7/40

(54) **Digital modulation**
Digitale Modulation
Modulation numérique

(30) Priority: 27.12.1990 JP 414666/90
(43) Date of publication of application: 01.07.1992
(73) Proprietor: SONY CORPORATION, Tokyo 141 (JP)
(72) Inventor: Isozaki, Masaaki, c/o Patents Division, Shinagawa-ku Tokyo 141 (JP)
(74) Representative: Harris, Ian Richard

(56) References cited:
- EP-A- 0 144 449
- US-A- 4 394 641
- US-A- 4 833 471
- US-A- 4 870 572

## Description

This invention relates to digital modulation, particularly, but not exclusively, for high density data recording.

The so-called D-2 format, currently employed in a composite digital video tape recorder, makes use of an M code (Modified Miller Code) as a code system for digital modulation. This M code uses a non-blocked system, and has excellent characteristics.

If the period of a train of modulated signals is T, then the minimum length T_{MIN} between transitions, that is the minimum distance between a point of signal inversion or transition and the next point of transition, is given by T_{MIN}=1.0T.

The maximum length T_{MAX} between transitions, that is the maximum distance between a point of signal inversion or transition and the next point of transition, is given by T_{MAX}=3.0T.

The window margin T_{w}, which is a measure of the tolerance, or how much variation in the signal time axis can be tolerated without code error, is given by T_{W}=0.5T.

The most significant feature of the M code is that it is free of dc components. The digital sum value (DSV), used in a known manner in evaluating the dc components of modulated signals, gives a measure of the dc components as the value of the sum total of scores +1 and -1, with the score +1 and the score -1 being given to a high level "1" and a low level "-1" of a code data waveform, respectively. With the M code, occurrences of level transitions are controlled so that the DSV value is within ±3, so as to render the code dc-free. The M code, thus being dc-free, significantly favours system implementation.

The minimum length T_{MIN} between transitions is as high as 1.0T to provide for the possibility of high recording density. Data recording or the like in accordance with this format permits high quality data transmission or the like.

However, there is a move towards a still higher recording density in data recording, that is, using a shorter wavelength and a narrower track.

For tracking accuracy in excess of a predetermined tolerance value, a narrower track width is used, and data need to be read using a reproducing magnetic head having a width greater than the track width. In such a case, the reproducing magnetic head reads out data recorded on adjacent tracks. That is, cross-talk occurs between adjacent tracks, so the S/N ratio is deteriorated. This cross-talk between adjacent tracks is worst in a recording wavelength region for which the azimuth loss effect of the magnetic head is diminished, that is, at lower frequencies.

According to the present invention there is provided a digital modulation method for converting 8-bit data of a binary system, wherein each bit indicates one of two binary values "1" or "0", into binary 16-bit data of the same binary system, said modulation method comprising: a first step of sequentially separating 8-bit data from an input data string;
a second step of forming a number of different 16-bit data of from 1st to 16th bits, satisfying the following conditions (1) to (6), for each of said 8-bit data;
(1) the number of consecutive "0"s or "1"s from the 2nd to the 15th bits is two or more;
(2) the number of consecutive "0"s or "1"s from the 1st to the 16th bits is five or less;
(3) the number of consecutive "0"s or "1"s from the 13th to the 16th bits is four or more;
(4) the absolute value of the code word digital sum CDS, obtained upon summing scores "+1" and "-1" for said binary values of "1" and "0", respectively, for the 1st to 16th bits, is four or less;
(5) the absolute value of the code word digital sum CDS(k), obtained upon summing scores "+1" and "-1" for said binary values of "1" and "0", respectively, for the 1st to kth bits, where 1≤k≤16, is five or less; and
(6) when the 16-bit data are converted into serial data which are then coupled together and outputted, the number of consecutive "0"s and "1"s in any part of the outputted serial data is not less than two and not more than five, and the value of DSV, obtained as the sum of scores "+1" and "-1", for said binary values of "1" and "0", respectively, is not more than three; and
   a third step of converting the 16-bit data from the second step into serial data and coupling the serial 16-bit data for outputting as coupled modulated digital data.

According to the present invention there is also provided apparatus for digital modulation for converting 8-bit data of a binary system, wherein each bit indicates one of two binary values of "1" or "0", into binary 16-bit data of the same binary system, the apparatus comprising:
first means for sequentially separating 8-bit data from an input data string;
second means for forming a number of different 16-bit data of from 1st to 16th bits, satisfying the following conditions (1) to (6), for each of said 8-bit data:
   (1) the number of consecutive "0"s or "1"s from the 2nd to the 15th bits is two or more;
   (2) the number of consecutive "0"s or "1"s from the 1st to the 16th bits is five or less;
   (3) the number of consecutive "0"s or "1"s from the 13th to the 16th bits is four or more;
   (4) the absolute value of the code word digital sum CDS, obtained upon summing scores "+1" and "-1" for said binary values of "1" and "0", respectively, for the 1st to 16th bits, is four or less;
   (5) the absolute value of the code word digital sum CDS(k), obtained upon summing scores "+1" and "-1" for said binary values of "1" and "0", respectively, for the 1st to kth bits, where 1≤k≤16, is five or less; and
   (6) when the 16-bit data are converted into serial data which are then coupled together and outputted, the numbers of consecutive "0"s and "1"s in any part of the outputted serial data is not less than two and not more than five, and the value of DSV, obtained as the sum of scores "+1" and "-1", for said binary values of "1" and "0", respectively, is not more than three; and
      third means for converting the 16-bit data from the second step into serial data and coupling the serial 16-bit data for outputting as coupled modulated digital data.

An embodiment of the present invention provides a digital modulation system in which a string of input data is divided at an interval of eight bits and the resulting 8-bit data are converted into 16-bit digital modulation code data. These 16-bit digital modulation code data satisfy the conditions that the consecutive number of "0"s or "1"s is two or more between the 2nd bit and the 15th bit, the consecutive number of "0"s or "1"s between the 1st bit and the 16th bit is five or less, the consecutive number of "0"s or "1"s between the 13th bit and the 16th bit is four or less, the absolute value of the code word digital sum CDS of the 16 bits of the modulation code data, used for calculating a digital sum value (DSV), is four or less, and the absolute value of the code word digital sum from the leading bit to a kth bit in the modulation code data, or the CDS(k), k being arbitrary, is five or less. In addition, the number of consecutive "0"s or "1"s in any portion of digital data produced upon consecutively transmitting or recording 16-bit digital modulation code data satisfying the above conditions is not less than two and not more than five, the 16-bit digital modulation code data being substantially dc-free, and the absolute value of the DSV being not more than three.

With a digital modulation system according to the present invention, as compared with the M code system, such parameters as the minimum length T_{MIN} between transitions and the window margin T_{w} are maintained at the same values as those for the M code system, while the maximum length T_{MAX} between transitions is less than that in the M code. As a result, the low frequency components may be diminished as compared with the case of the M code.

Because of the lower content of the low frequency components, cross-talk between adjacent tracks during recording may be diminished to improve an S/N ratio.

Even although the minimum recording wavelength, that is the minimum length between transitions, used for recording, is equal to that with the M code, clocks may be locked with a PLL system at the reproducing side more easily because the maximum length T_{MAX} between transitions is as short as 2.5T.

Moreover, the erasure rate during overwriting may be improved due to higher spectral concentration.

In addition, it becomes possible to diminish the peak shift of recording data produced during recording.

The invention will now be described by way of example with reference to the accompanying drawings, throughout which like parts are referred to by like references, and in which:
Figure 1 is a status transition diagram showing status transition of a digital modulation system;
Figure 2 is a block circuit diagram showing an encoder of the digital modulating system;
Figure 3 is a block circuit diagram showing a decoder of the digital modulating system; and
Figure 4 is a graph showing frequency characteristics for an M code conversion system and the present 8-16 conversion system.

With the present digital modulation system, input data are divided at an interval of 8 bits, and the resulting 8-bit data are converted into 16-bit modulated coded digital data. Specifically, there are 2⁸ possible input 8-bit binary data, that is, 256 possible input data, whereas there are 2¹⁶ possible 16-bit binary signals, in other words, 256 8-bit input data are converted into a possible 65,536 16-bit data.

Thus a plurality of candidate conversion codes may correspond to each of the input data. Since it is necessary to select conversion codes from those candidate conversion codes quickly, and so that the selected conversion codes are dc-free and free from low frequency components to give low error rates, those conversion codes which will satisfy the following conditions are previously arranged as conversion tables (table columns). That is, with the 8-16 conversion code, the input data are modulated so that there are two or more consecutive "0"s or "1"s from the 2nd bit to the 15th bit of the above mentioned 16-bit conversion code data; there are five or less consecutive "0"s or "1"s between the 1st bit and the 16th bit of the 16-bit conversion code data; there are four or less consecutive "0"s or "1"s between the 13th bit and the 16th bit of the 16-bit conversion code data; the absolute value of the code word digital sum CDS of the 16 bits of the modulation code, produced when calculating a digital sum value (DSV) by summing "1"s and "0"s of the bits in the modulation code data as "+1" and "-1", respectively, is four or less; and the absolute value of the code word digital sum from the leading bit to an arbitrarily selected kth bit in the modulation code data, or CDS(k), is five or less.

The above is the conversion rule when modulation code data according to the 8-16 digital conversion system, or a modulation code block, is treated by itself. If a plurality of these modulation code blocks are arrayed in juxtaposition to each other, those modulation code data which are more desirable as the digital data in their entirety are selected from the plurality of candidate modulation codes corresponding to each of the 256 data.

Specifically, with the present conversion code, not only the above conditions need to be satisfied, but also coupling between adjacent code blocks need to be taken into account, as will be explained subsequently. That is, in any portion of consecutively transmitted or recorded digital data, the number of consecutive "0"s or "1"s is two or more and five or less, there should be no dc components, and the absolute value of the DSV is three or less. Each of the 8-bit data divided from the input data string is modulated by selecting the modulation data associated with the input data. If the coupling between adjacent modulation code blocks is selected to satisfy the conditions which will be explained subsequently, the sum of the waveform levels or DSV equals zero or equals ±2. For quickly selecting the conversion codes corresponding to the input data responsive to these states, several conversion tables are provided in the present embodiment, as will be explained subsequently.

Several specific examples of modulation codes conforming to the above modulation rule are given below.

In the first place, the digital sum value DSV, represented by the sum of the digital waveform levels of the coded data or bits, wherein "1" and "0" are treated as the digital waveform levels "+1" and "-1", respectively, is used as an index for judging whether the modulation code is free of dc components, that is, dc-free.

Secondly, the code word digital sum CDS, indicating the sum of code waveform levels, indicates the sum of all of the digital waveform levels within each 16-bit modulation code data.

Thirdly, CDS(k), one of the sums of the code word waveform levels, indicates the sum of the digital code word waveform levels from the leading bit to an arbitrary bit of each modulation code data.

Similarly, the sum of the waveform levels of an nth 16-bit modulation code DSV(n), as found in accordance with the above rule, represents the sum of the digital waveform levels of the coded data or bits from a past until the current time point. In other words, the sum of the digital waveform levels DSV(n) of the 16-bit modulation code at the current time point represents the sum of the digital waveform levels of the 16-bit modulation code data up to the (n-1)th modulation code block and the digital waveform levels of the current 16-bit modulation code block.

The above three types of level sum values are represented by the following equations: 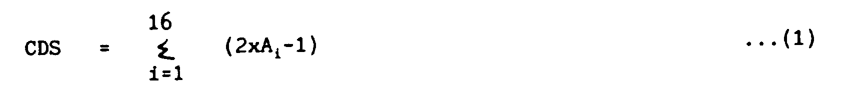 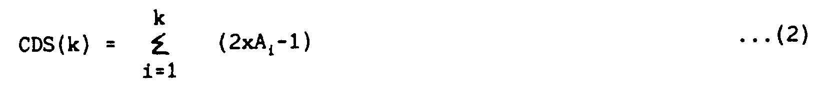 $\text{DSV(n) = DSV(n-1)öCDS}$

In the above equations, the superscripts k assume a value of 1≤k≤16, and the variable n represents that the modulation code block is the nth 16-bit code block among the 16-bit modulation code blocks, whilst Aᵢ in equations 1 and 2 indicates the value of the bits, which may be binary "1" or "0".

With the above-mentioned modulation codes in which all of the conditions of the above-mentioned modulation rule for converting the 8-bit digital data into 16-bit digital conversion code data are satisfied, the value of the sum of the waveform levels or DSV of the modulated code data from a past until the current time, is either equal to zero or equal to ±2, if the conditions that, in any of the portions of continuously transmitted or recorded digital data taking account of coupling between adjacent code blocks, the number of consecutive "0"s or "1"s is two or more to five or less, the dc components are eliminated and the absolute value of the DSV is three or less, should be satisfied.

Using the above symbols and equations, this will be further explained with reference to Tables 1 to 5.

**TABLE 1**

| | DSV=0 | | DSV=+2 | DSV=-2 |
|---|---|---|---|---|
| 0(00H) | CDS=0 00∼11 | CDS=0 11∼00 | CDS=0 00∼11 | CDS=0 11∼00 |
| | -3≦CDSP≦1 | 1≦CDSP≦3 | -3≦CDSP≦1 | -1≦CDSP≦3 |
| | | | | |
| | CDS=+2 00∼11 | CDS=-2 11∼00 | CDS=0 00∼11 | CDS=0 11∼00 |
| | -3≦CDSP≦3 | -3≦CDSP≦3 | CDSP _{MIN} = 4, -5 | CDSP_{MAX} = 4, 5 |
| | | | | |
| | CDS=0 00∼11 | CDS=0 11∼10 | CDS=-2 00∼01 | CDS=+2 11∼10 |
| | -3≦CDSP≦3 | -3≦CDSP≦3 | 00∼11 | 11∼00 |
| | | | -5 ≦ CDSP ≦ 1 | -1 ≦ CDSP ≦ 5 |
| | | | | |
| | CDS=0 00∼11 | CDS=0 11∼00 | CDS=-4 10∼00 | CDS=+4 01∼11 |
| | CDSP_{MAX} = 2, 3 | CDSP_{MIN} =-2, -3 | -5≦CDSP≦1 | -1 ≦CDSP ≦ 5 |
| | | | | |
| | CDS=0 01∼01 | CDS=0 10∼10 | CDS=-2 10∼10 | CDS=+2 01∼01 |
| | 01∼11 | 10∼10 | | |
| | -3≦CDSP≦3 | -3≦CDSP≦3 | -5≦CDSP≦1 | -1≦CDSP≦5 |
| | | | | |
| | CDS=+2 01∼11 | CDS=-2 10∼00 | CDS=-2 10∼00 | CDS=+2 01∼11 |
| | CDSP_{MIN}=-2, -3 | CDSP_{MAX} =2, 3 | CDSP_{MIN} =-4, -5 | CDSP_{MAX} = 4, 5 |
| | | | | |
| | CDS=+2 01∼11 | CDS=-2 10∼00 | CDS=-2 10∼00 | CDS=+2 01∼11 |
| | -1≦CDSP≦3 | -3≦CDSP≦1 | -3≦CDSP≦1 | -1≦CDSP≦3 |
| | | | | |
| | CDS=-2 00∼00 | CDS=+2 11∼11 | CDS=-2 00∼00 | CDS=+2 11∼11 |
| 127(7FH) | -3≦CDSP≦1 | -1≦CDSP≦3 | -3≦CDSP≦1 | -1≦CDSP≦3 |
| | | | | |
| 128(80H) | CDS=0 00∼00 | CDS=0 11∼11 | CDS=-2 00∼00 | CDS=+2 11∼11 |
| | 00∼10 | 11∼01 | | |
| | -3≦CDSP≦3 | -3≦CDSP≦3 | CDSP_{MIN} = 4,-5 | CDSP_{MAX} = 4, 5 |
| | | | | |
| | CDS=-2 00∼00 | CDS=+2 11∼11 | CDS=-4 00∼00 | CDS=+4 11∼11 |
| | CDSP_{MAX} =2, 3 | CDSP_{MIN} =-2, -3 | -5≦CDSP≦1 | -1≦CDSP≦5 |
| | | | | |
| | CDS=-2 01∼00 | CDS=+2 10∼11 | CDS=- 2 00∼10 | CDS=+2 11∼01 |
| | -3≦CDSP≦3 | -3≦CDSP≦3 | -5≦CDSP≦1 | -1≦CDSP≦5 |
| | | | | |
| | CDS=0 01∼10 | CDS=0 10∼01 | CDS=-2 10∼11 | CDS=+2 01∼00 |
| | -3≦CDSP≦3 | -3≦CDSP≦3 | -5≦CDSP≦1 | -1≦CDSP≦5 |
| | | | | |
| | CDS=0 01∼00 | CDS=0 10∼11 | CDS=-2 10∼01 | CDS=+2 01∼10 |
| | CDSP _{MIN}=-2, -3 | CDSP _{MAX}=2, 3 | -5≦CDSP≦1 | -1≦CDSP≦5 |
| | | | | |
| | CDS=0 01∼00 | CDS=0 10∼11 | CDS=0 10∼11 | CDS=0 01∼00 |
| 255(FFH) | -1≦CDSP≦3 | -3≦CDSP≦1 | -3≦CDSP≦1 | -1≦CDSP≦3 |

**TABLE 2**

| | Table Column 0 | CDS | JT |
|---|---|---|---|
| : | : | : | : |
| : | : | : | : |
| 120 | 0111000111100011 | 2 | 1 |
| 121 | 0111001100110011 | 2 | 1 |
| 122 | 0111001110000111 | 2 | 1 |
| 123 | 0111100001100111 | 2 | 1 |
| 124 | 0111100001110011 | 2 | 1 |
| 125 | 0111100011000111 | 2 | 1 |
| 126 | 0111100011100011 | 2 | 1 |
| 127 | 0111100110000111 | 2 | 1 |
| 128 | 0001100110011100 | -2 | 1 |
| 129 | 0001100111001100 | -2 | 1 |
| 130 | 0001110001111000 | -2 | 1 |
| 131 | 0001110011001100 | -2 | 1 |
| 132 | 0001111000011100 | -2 | 1 |
| 133 | 0001111000111000 | -2 | 1 |
| 134 | 0011000110011100 | -2 | 1 |
| 135 | 0011000111001100 | -2 | 1 |
| 136 | 0011001100011100 | -2 | 1 |
| 137 | 0011001100111000 | -2 | 1 |
| 138 | 0011001110001100 | -2 | 1 |
| 139 | 0011001110011000 | -2 | 1 |
| 140 | 0011100001111000 | -2 | 1 |
| 141 | 0011100011001100 | -2 | 1 |
| 142 | 0011100110001100 | -2 | 1 |
| 143 | 0011100110011000 | -2 | 1 |
| 144 | 0001100110011110 | 0 | 0 |
| 145 | 0001100111001110 | 0 | 0 |
| 146 | 0001100111100110 | 0 | 0 |
| 147 | 0001110001111100 | 0 | 0 |
| 148 | 0001110011001110 | 0 | 0 |
| 149 | 0001110011100110 | 0 | 0 |
| 150 | 0001110011111000 | 0 | 0 |
| : | : | : | : |
| : | : | : | : |

**TABLE 3**

| | Table Column 1 | CDS | JT |
|---|---|---|---|
| : | : | : | : |
| : | : | : | : |
| 120 | 1000111000011100 | -2 | 1 |
| 121 | 1000110011001100 | -2 | 1 |
| 122 | 1000110001111000 | -2 | 1 |
| 123 | 1000011110011000 | -2 | 1 |
| 124 | 1000011110001100 | -2 | 1 |
| 125 | 1000011100111000 | -2 | 1 |
| 126 | 1000011100011100 | -2 | 1 |
| 127 | 1000011001111000 | -2 | 1 |
| 128 | 1110011001100011 | 2 | 1 |
| 129 | 1110011000110011 | 2 | 1 |
| 130 | 1110001110000111 | 2 | 1 |
| 131 | 1110001100110011 | 2 | 1 |
| 132 | 1110000111100011 | 2 | 1 |
| 133 | 1110000111000111 | 2 | 1 |
| 134 | 1100111001100011 | 2 | 1 |
| 135 | 1100111000110011 | 2 | 1 |
| 136 | 1100110011100011 | 2 | 1 |
| 137 | 1100110011000111 | 2 | 1 |
| 138 | 1100110001110011 | 2 | 1 |
| 139 | 1100110001100111 | 2 | 1 |
| 140 | 1100011110000111 | 2 | 1 |
| 141 | 1100011100110011 | 2 | 1 |
| 142 | 1100011001110011 | 2 | 1 |
| 143 | 1100011001100111 | 2 | 1 |
| 144 | 1110011001100001 | 0 | 0 |
| 145 | 1110011000110001 | 0 | 0 |
| 146 | 1110011000011001 | 0 | 0 |
| 147 | 1110001110000011 | 0 | 0 |
| 148 | 1110001100110001 | 0 | 0 |
| 149 | 1110001100011001 | 0 | 0 |
| 150 | 1110001100000111 | 0 | 0 |
| : | : | : | : |
| : | : | : | : |

**TABLE 4**

| | Table Column 4 | CDS | JT |
|---|---|---|---|
| : | : | : | : |
| 30 | 0011000011100111 | 0 | 1 |
| 31 | 0011000011110011 | 0 | 1 |
| 32 | 0011000110001111 | 0 | 1 |
| 33 | 0011001100001111 | 0 | 1 |
| 34 | 0000011100110011 | -2 | 0 |
| 35 | 0000011100111001 | -2 | 0 |
| 36 | 0000011110000111 | -2 | 0 |
| 37 | 0000011110011001 | -2 | 0 |
| 38 | 0000110001110011 | -2 | 0 |
| 39 | 0000110001111001 | -2 | 0 |
| 40 | 0000110011000111 | -2 | 0 |
| : | : | : | : |
| 90 | 1000110001110000 | -4 | 1 |
| 91 | 1000110000111000 | -4 | 1 |
| 92 | 1000110000011100 | -4 | 1 |
| 93 | 1000011100110000 | -4 | 1 |
| 94 | 1000011100011000 | -4 | 1 |
| 95 | 1000011100001100 | -4 | 1 |
| 96 | 1000011001110000 | -4 | 1 |
| 97 | 1000011000111000 | -4 | 1 |
| 98 | 1000011000011100 | -4 | 1 |
| 99 | 1000001110011000 | -4 | 1 |
| 100 | 1000001100011100 | -4 | 1 |
| 101 | 1000111000001110 | -2 | 0 |
| 102 | 1000110011000110 | -2 | 0 |
| 103 | 1000110001100110 | -2 | 0 |
| 104 | 1000110000011110 | -2 | 0 |
| 105 | 1000011110000110 | -2 | 0 |
| : | : | : | : |
| 185 | 0011000110011000 | -4 | 1 |
| 186 | 0011001100001100 | -4 | 1 |
| 187 | 0011001100011000 | -4 | 1 |
| 188 | 0011001100110000 | -4 | 1 |
| 189 | 0011100000111000 | -4 | 1 |
| 190 | 0011100001110000 | -4 | 1 |
| 191 | 0000011100011110 | -2 | 0 |
| : | : | : | : |
| 241 | 1001100110000111 | 0 | 1 |
| 242 | 1001100011100011 | 0 | 1 |
| 243 | 1001100011000111 | 0 | 1 |
| 244 | 1001100001110011 | 0 | 1 |
| 245 | 1001100001100111 | 0 | 1 |
| 246 | 1000111001100011 | 0 | 1 |
| 247 | 1000111000110011 | 0 | 1 |
| 248 | 1000110011100011 | 0 | 1 |
| : | : | : | : |

**TABLE 5**

| | Table Column 5 | CDS | JT |
|---|---|---|---|
| : | : | : | : |
| 30 | 1100111100011000 | 0 | 1 |
| 31 | 1100111100001100 | 0 | 1 |
| 32 | 1100111001110000 | 0 | 1 |
| 33 | 1100110011110000 | 0 | 1 |
| 34 | 1111100011001100 | 2 | 0 |
| 35 | 1111100011000110 | 2 | 0 |
| 36 | 1111100001111000 | 2 | 0 |
| 37 | 1111100001100110 | 2 | 0 |
| 38 | 1111001110001100 | 2 | 0 |
| 39 | 1111001110000110 | 2 | 0 |
| 40 | 1111001100111000 | 2 | 0 |
| : | : | : | : |
| 90 | 0111001110001111 | 4 | 1 |
| 91 | 0111001111000111 | 4 | 1 |
| 92 | 0111001111100011 | 4 | 1 |
| 93 | 0111100011001111 | 4 | 1 |
| 94 | 0111100011100111 | 4 | 1 |
| 95 | 0111100011110011 | 4 | 1 |
| 96 | 0111100110001111 | 4 | 1 |
| 97 | 0111100111000111 | 4 | 1 |
| 98 | 0111100111100011 | 4 | 1 |
| 99 | 0111110001100111 | 4 | 1 |
| 100 | 0111110011100011 | 4 | 1 |
| 101 | 0111000111110001 | 2 | 0 |
| 102 | 0111001100111001 | 2 | 0 |
| 103 | 0111001110011001 | 2 | 0 |
| 104 | 0111001111100001 | 2 | 0 |
| 105 | 0111100001111001 | 2 | 0 |
| : | : | : | : |
| 185 | 1100111001100111 | 4 | 1 |
| 186 | 1100110011110011 | 4 | 1 |
| 187 | 1100110011100111 | 4 | 1 |
| 188 | 1100110011001111 | 4 | 1 |
| 189 | 1100011111000111 | 4 | 1 |
| 190 | 1100011110001111 | 4 | 1 |
| 191 | 1111100011100001 | 2 | 0 |
| : | : | : | : |
| 241 | 0110011001111000 | 0 | 1 |
| 242 | 0110011100011100 | 0 | 1 |
| 243 | 0110011100111000 | 0 | 1 |
| 244 | 0110011110001100 | 0 | 1 |
| 245 | 0110011110011000 | 0 | 1 |
| 246 | 0111000110011100 | 0 | 1 |
| 247 | 0111000111001100 | 0 | 1 |
| 248 | 0111001100011100 | 0 | 1 |
| : | : | : | : |

The item JT shown in the above Tables 2 to 5 will be explained in connection with a state transition diagram.

The sum of the waveform levels DSV of the current nth 16-bit modulation code block, shown by equation 3, is indicated at the head of the columns of Table 1. CDSP in Table 1 indicates the sum of the waveform levels from the leading bit to an arbitrary bit of a 16-bit modulation code block, and corresponds to the above-mentioned CDS(k).

The conditions with the sum of the waveform levels DSV=0 in Table 1, are as follows: Not only the above-mentioned 8-16 conversion rules are satisfied, but also the number of consecutive "0"s or "1"s in a beginning portion of each code block is four or less, the absolute value of the sum of the digital coded waveform levels of coded bit data in the modulated code block is three or less, that is, | CDS(k) | ≤3, with the code digital sum CDS being zero. Alternatively, with the sum of coded digital levels of 16-bit coded data or CDS being -2, the beginning bit of the coded block is "0" and the end of the coded block is two contiguous "0"s or "...00", or the beginning bit of the coded block is "0" and the end of the coded block is two contiguous "1"s or "...11".

It is apparent that, with the modulated code data having the above-mentioned three patterns, the above conditions may be fully met when the data of the 16 bits are complemented.

For example, NRZ modulated code data 144 to 150 shown in table column 0 shown in Table 2, satisfy the conditions that the number of contiguous "0"s or "1"s at the beginning of the block is four or less and the relation | CDS(k) | ≤3 is met, with the code digital sum CDS being zero.

Referring then to table column 1 of Table 3, the data satisfying the above conditions may be prepared by complementing the 16-bit data of the modulated code block shown in table column 0. The data satisfying these conditions are the modulated NRZ code data 144 to 150 shown in table column 1 of Table 3. The code digital sum CDS of the 16 bit data, calculated by equation 1, is found to be equal to zero.

In addition to the above-mentioned codes, there is also a modulated code for the digital sum value DSV=0 in which the code digital sum CDS of the 16-bit coded data is -2, the beginning part of the block is "0..." and the end of the block is "...00". The modulated input NRZ code data 128 to 143 shown in table column 0 of Table 2 represent the modulated code data satisfying the above conditions.

There is also a modulation code in which the code digital sum CDS is +2, the beginning part of the code block is "0..." and the end part is two contiguous "1"s or "...11". The modulated NRZ code data 120 to 127 shown in table column 0 of Table 2 correspond to the modulation code satisfying the above conditions.

The modulation code data prepared by complementing the 16-bit data of the modulated input NRZ data shown in table column 0 of Table 2 are shown in table column 1 of Table 3.

The 16-bit modulated code data shown in Table 1 are converted from NRZ input data 0 to 255 in such a manner that, with DSC=0, the number of contiguous "0"s or "1"s in any portion of interlinked code blocks is two to five, there are no dc components, and the absolute value of the DSV is three or less. whereby the above 8-16 conversion rule is satisfied, and coupling between the code words is taken into account.

Another table for modulated code blocks is prepared on the basis of DSV=±2 wherein the above 8-16 conversion rule is met, and the coupling between adjacent code blocks is also taken into account.

In such other table for modulation codes, there are a case where the sum of waveform levels DSV=+2 and a case wherein DSV=-2. It is seen from Table 1 that the relation between these two cases is such that the bits of the modulated code blocks are complemented so that the signs of the DSVs are opposite to each other. In addition, the absolute value of the sum of the digital levels of the coded data from the leading bit to an arbitrary kth bit or CDS(k) is five or less in both of these cases. It may be seen from this that the modulation code system satisfies the above condition when DSV=+2 and -2, wherein the signs are opposite to each other.

For this reason, the condition for DSC=+2 will be explained, while the opposite case of DSV=-2 will be omitted.

In the first place, for DSV=+2, the sum of the absolute values of the digital levels of the above-mentioned coded data from the leading bit to an arbitrary bit in the modulated code need to be five or less, that is, the absolute value of the sum of digital levels to an arbitrary bit in the code block should be such that -5≤CDS(k)≤1, in order that the 8-16 conversion rule and also the conditions shown in Table 1 are met. It is now envisaged to prepare a modulation code in which, in the modulation code with -5≤CDS(k)≤1, coupling at the neighbouring code blocks is additionally taken into account.

Among the modulation codes for which DSV=+2 and | CDS(K) | ≤5, the following six conditions are thought of as the 16-bit modulation code which will satisfy the condition 5≤CDS(K)≤1.

For DSV=+2, the first condition is that the code digital sum CDS of the 16-bit data is zero, the beginning starts "00...", and the end part is constituted by consecutive "1"s, namely "...11".

The second condition is that the code digital sum CDS is zero, the beginning starts with "1" and "0", that is with "10...", and the end terminates with consecutive "1"s, namely with "...11".

The third condition is that the code digital sum CDS is -2, the beginning starts with consecutive "0"s, namely with "00...".

The fourth condition is that the code digital sum CDS is -2 and the beginning starts with "10...".

The fifth condition is that the code digital sum CDS is -4, the beginning starts with "00...", and the end part is terminated with consecutive "0"s, namely with "...00".

The sixth condition is that the code digital sum CDS is -4, as above, and the beginning starts with consecutive "0"s, that is, with "00...", and the end part is terminated with consecutive "0"s, namely with "...00".

The above first to sixth conditions are met in a table column 4 of Table 4. For example, the modulated code satisfying the first condition corresponds to that for modulated input NRZ code data 30 to 33. The modulated code satisfying the second condition corresponds to that for modulated input NRZ code data 241 to 248. The modulated code satisfying the third condition corresponds to that for modulated input NRZ code data 34 to 40 and 191. The modulated code satisfying the fourth condition corresponds to that for modulated input NRZ code data 101 to 105. The modulated code satisfying the fifth condition corresponds to that for modulated input NRZ code data 185 to 190. The modulated code satisfying the sixth condition corresponds to that for modulated input NRZ code data 90 to 100.

It is similarly seen that, with the sum of levels or digital sum value DSV=-2, the absolute value of the sum of digital levels from the leading bit to an arbitrary kth bit of the 16-bit data or CDS(k) is given by -1≤CDS(k)≤5. Table 5 shows a modulated code block within the above range of the CDS(k) in which additionally the coupling with the adjoining code blocks is taken into account.

The modulation codes for the input NRZ data 0 to 255 for DSV=±2, are shown in Table 1.

The modulated codes for DSV=±2 satisfy the above first to sixth conditions.

The bit data shown in table column 4 in Table 4 are complemented from the corresponding 16-bit data of the modulation code corresponding to the modulated NRZ code data, shown in table column 5 of Table 5, similarly to the data of the table column 0 of Table 2 which are complemented from the data shown in table column 1 of Table 3.

With the present 8-16 conversion, since a plurality of conversion codes correspond to only one input data, and it is necessary to select quickly the dc-free conversion code corresponding to the input data, tables for the modulation codes which will satisfy the above conditions are prepared in advance. These tables are written in, for example, a read-only memory (ROM) from which corresponding data are read out for digitally modulation the input NRZ data. Six such tables which will satisfy the above mentioned 8-16 conversion rule, and the rule concerning the coupling between adjacent code blocks are employed in the present embodiment. In the following, the formulation of these tables is explained.

For DSV = 0, modulation codes for association with NRZ data to be modulated are first prepared, using tables columns 0 and 2.

With table column 0, table column data are divided into two, depending on whether the beginning part of the modulation code is started with "00... or with "01...".

For DSV = 0 as above, with table column 2, table column data are divided into two, depending on whether the beginning of the modulation code starts with "00..." or with "11...".

With tables columns 1 and 3, the total of 16 bits are complemented from the bits of the table columns 0 and 2, respectively.

With table column 1, table column data are divided into two depending on whether the beginning part of the conversion starts with "11..." or with "10...".

With table column 3, table column data are divided into two depending on whether the beginning of the conversion starts with "11 or with "01...".

In this manner, with DSV=0, four tables columns are formulated depending on the above-mentioned different sets of data.

These tables columns may be associated with the original NRZ data in any desired manner.

As for the table columns for DSV=±2, table column data are similarly divided into two depending on whether the starting portion of the modulation code is "00..." or "10...", whilst the 16 bits are complemented to produce table column data composed of modulated codes beginning with "11..." and "01...". Two table columns, namely table columns 4 and 5, are prepared from the combination of the formulated data. These table for DSV=±2 similarly may be associated with the original NRZ data in any desired manner.

In this manner, six table columns may be prepared for use in digital modulation.

The conditions for selection among these six table columns will be explained below.

In these conditions for selecting the table columns, the conditions for coupling the modulation codes are of critical importance because the conditions that need to be satisfied are that the number of consecutive numbers "0" or "1" in any portion of consecutively transmitted or recorded data be two or more and five or less, the dc components are eliminated, and the absolute value of the digital sum value DSV is three or less.

In selecting the table columns so as to satisfy the above conditions, table columns 0 to 5 are selected by the last two bits of a block preceding the current block depending on the value of the DSV up to the current block equal to 0 or ±2.

Table column 0 is selected when DSV=0 and the end part of the preceding block is "1" and "0", that is "...10".

Table column 1 is selected when DSV=0 and the end part of the preceding block is "0" and "1", that is "...01".

Table column 2 is selected when DSV=0 and the end part of the preceding block is "1" and "1", that is "...11".

Table column 3 is selected when DSV=0 and the end part of the preceding block is "0" and "0", that is "...00".

Table column 4 is selected when DSV=±2 and the end part of the preceding block is "1" and "1", that is "...11".

Table 5 is selected when DSV=±2 and the end part of the preceding block is "0" and "0" that is "...00"

Although a digital modulation system with six tables has been shown in the foregoing, only two tables may suffice for conversion by using a table indicating complemented data of the preceding bit of the code word.

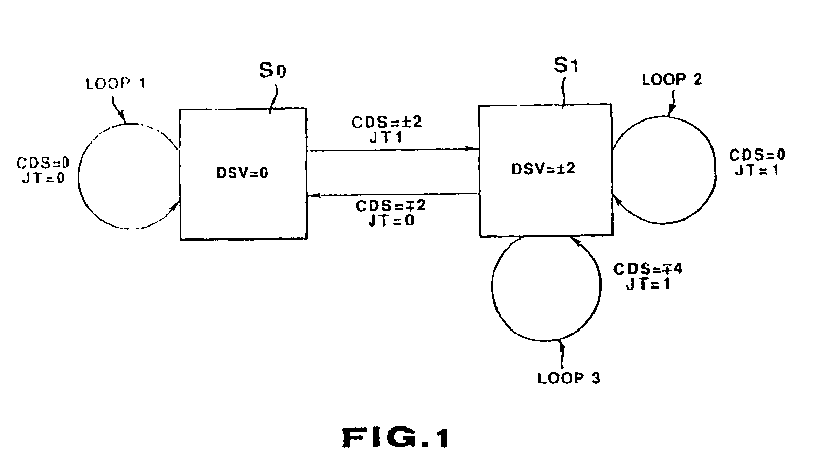

This 8-16 conversion system is operated in according with the status transition shown in Figure 1.

The symbols used in Figure 1 will first be explained.

The code digital level sum CDS, the sum of waveform levels CDS(k) from the leading bit to an arbitrary bit within the modulation code and the sum of waveform levels DSV, are given by equations 1, 2 and 3 above.

Referring to Figure 1, the item or status symbol JT, indicating if there occurs a status transition in the 8-16 conversion, may assume one or two status values, so that the symbols JT indicating the status transition may be represented by 1-bit binary data. Also, in actual circuit operation, the symbol JT indicating the status transition selects one of the states S₀ and S₁ which will be explained subsequently. More specifically, the symbol JT is used for selecting one of the tables for DSV=0 or =±2, in each of which the data to be used for modulation by 8-16 conversion are stored.

Referring to Figure 1, the digital sum value DSV=0 indicates the state S₀, whilst the digital sum value DSV=± indicates the state S₁. For example, a state in which the digital sum value DSV(n-1) in the 16-bit (n-1)th modulation code block in the first term of the right side of equation 3 is equal to zero, is indicated. With this state S₀, the digital sum value DSV(n) in the nth 16-bit modulation code block is zero. The symbol JT indicating if status transition occurs is zero (JT=0), so that, under these conditions, status transition is not produced, so that control reverts to state S₀ (loop 1).

Similarly, with the state S₀ in which the digital sum value DSV(n-1) within the (n-1)th modulated code block is zero, if the code digital level sum CDS(n) within the next nth 16-bit modulated code is ±2, that is, DSV(n)=±2, the symbol indicating whether or not status transition occurs is one (JT=1). Under these conditions, transition occurs from state S₀ to state S₁. At this time, the digital sum value DSV(n) of the nth 16-bit modulation code block is ±2, that is, DSV(n)=±2.

The next succeeding 8-16 conversion is effected at the state S which has been changed from the state S₀. The operation under this status S₁ will now be explained. The digital sum value DSV(n) in the nth 16-bit modulation code at the first term on the right side of equation 3 is ±2, that is, DSV(n)=±2. If, under this state S₁, the code digital level sum CDS(n+1) in the next (n+1)th modulation code block is zero, the digital sum value becomes equal to ±2, that is, DSV(n+1)=±2. The symbol JT indicating whether or not status transition occurs is one (JT=1), so that no status transition occurs and control reverts to state S₁ (loop 2).

On the other hand, if the digital sum value DSV(n) within the nth 16-bit modulation code block is equal to +2 and, in this state S₁, the code digital level sum CDS (n+1) within the next (n+1)th modulation code block is equal to -4, or if the digital sum value DSV(n) is equal to -2 and the code digital sum value CDS(n+1) within the next (n+1)th 16-bit modulated code block is equal to =4, the digital sum value DSV(n+1) is equal to -2 or to +2. The symbol JT indicating if status transition occurs is 1 (loop 3).

If, with the digital sum value DSV(n+1) within the (n+1)th modulation code block is equal to ±2, the code digital level sum COS(n+2) within the next (n+2)th 16-bit modulation code block is equal to -2 or +2, the digital sum value DSV(n+2) within the (n+2)th modulation code block becomes 0. Therefore, the symbol indicating status transition becomes 0 (JT=0), so that transition occurs from state S₁ to state S₀.

The status transition diagram of Figure 1 shows that if, with the digital sum value DSV=0, the code digital level sum within the next 16-bit modulation code block is equal to ±2, or if, with the digital sum value DSV =±2, the code digital level sum CDS within the next 16-bit modulation code block is equal to -2 or +2, status transition occurs.

Although there are two table columns in association with the above-mentioned states S₀ and S₁, there are 56 common modulation codes, so that there are 456 different codes in the 8-16 digital modulation system. Since three codes are used for synchronization, the number of codes for the present digital modulation system is ultimately 459.

Since status transition is highly simplified with the digital modulation system with 8-16 conversion, there is no need to calculate the digital sum value during digital modulation, and hence the hardware may be reduced by approximately 30% as compared to the case of the 8-14 modulation system (EFM).

With 8-16 conversion, it is necessary to reallocate the serial data into 16-bit parallel data at the time of decoding. Thus the present digital conversion system includes a self-locking pattern for indicating a code boundary for reallocation into 16-bit parallel data.

This self-locking pattern is checked by checking ten pattern bits of two consecutive blocks, namely four pattern bits of a preceding block and six pattern bits of a succeeding block. That is, the self-locking patterns having the duration of the same level is 2.5T each if, with the four pattern bits of the preceding block all "1" or "0", the first one of the six pattern bits of the next block assumes the same value "1" as the four pattern bits and the succeeding five bits are "0" or, conversely, if the first one of the six pattern bits and the succeeding five bits are "1".

In this code system, since the 2.5T-2.5T pattern occurs only at the time of coupling neighbouring code blocks, this pattern may be detected and utilized for self-locking.

Since the probability of occurrence of the self-locking pattern in the code word in the 8-16 modulation system is low, the self-locking pattern is included in the sync pattern and preamble pattern. However, since detection of synchronization becomes impossible if the self-locking is disengaged, it is necessary to diminish the probability of spurious locking to as low a value as possible.

It may therefore be envisaged to use 2.5T-3T and 3T-3T patterns as self-locking patterns, in which case the distance between the code blocks and between the code block and synchronization patterns may be extended by using patterns not included in the code system by 8-16 conversion, for thereby lowering the probability of spurious locking.

Since block codes are used in the present 8-16 digital modulation system, synchronization signals and errors may be detected easily.

On the other hand, with the present 8-16 digital modulation system, there may be an occasion wherein, due to the larger distance between the codes, there is only one code among the errors that has the closest Hamming distance. Therefore, since the error is most likely to have occurred at the code having the closest Hamming distance, it may be replaced by an error code and deemed to be an error code word so as to be decoded by so-called Hamming correction.

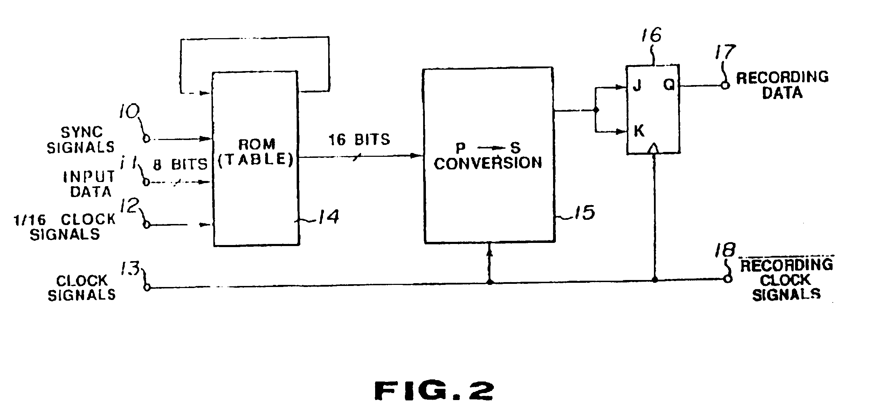

Referring to Figure 2, the circuit construction of an encoder will now be explained.

This encoder has a read-only memory (ROM) 14, to which synchronization signals and input data as code data to be modulated are entered by means of input terminals 10 and 11, respectively. These input data are NRZ data divided at an interval of 8 bits.

Clock signals for operating the decoder are supplied from an input terminal 12 to a parallel-to-serial converter 15 and to a clock terminal of a J-K flip-flop 16. The converter 15 outputs input parallel bits as serial bits. These clock signals are outputted as recording clock signals at an output terminal 18.

Clock signals having a frequency equal to 1/16 of the basic clock frequency are supplied via an input terminal 12 to the ROM 14.

A table select signal for selecting one of the six tables is outputted from and entered to the ROM 14. The conditions under which the table is selected include the digital sum value DSV and data assumed by the first two bits of the preceding code block, as discussed above.

The input 8-bit NRZ data to be modulated are converted from 8-bit to 16-bit modulation code data in accordance with the NRZ data having the selected table number of the ROM 14 in accordance with the above-mentioned table selection. The outputs from the ROM 14 are 16-bit parallel data.

The converter 15, outputting parallel input bits as serial bits, is supplied with output signals from the ROM 14 and converts these signals into serial 1-bit output signals by clocks supplied from the input terminal 13. These output signals are supplied to a J-terminal and a K-terminal of the flip-flop 16. The flip-flop 16 supplies output signals while the state of the signals is maintained or complemented depending on the state of signals supplied to the J and K terminals at the rise time of clock signals supplied to the clock terminal of the flip-flop 16 via the input terminal 13.

The output signals are outputted via the output terminal 17 as recorded data.

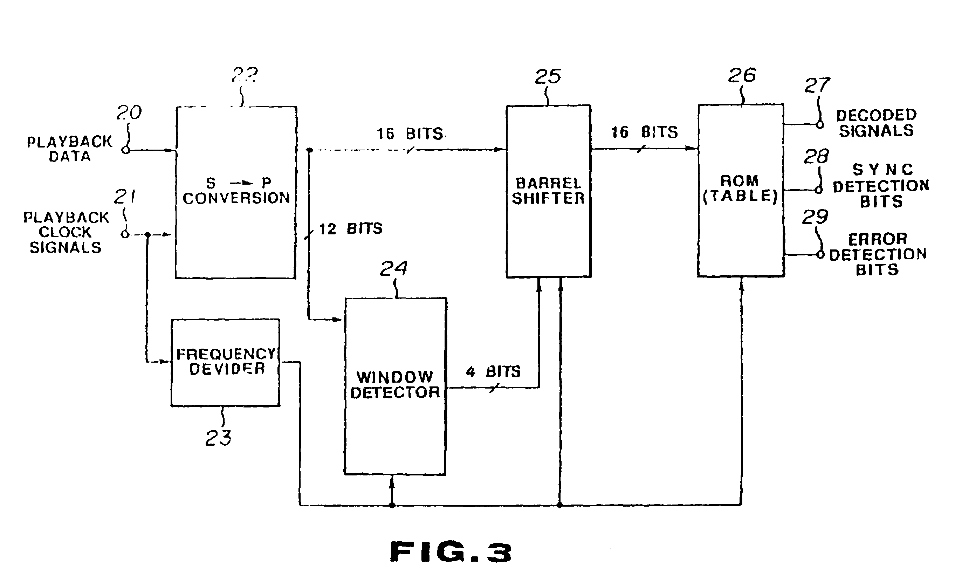

Referring to Figure 3, a decoder operating in accordance with the present 8-16 conversion system will be explained.

Playback data supplied via an input terminal 20, and playback clocks supplied via an input terminal 21 are supplied to a serial-to-parallel converter 22. The input playback data, supplied as serial data on a bit-by-bit basis, are converted into parallel data of a plurality of, for example, 16 bits, at the timing of the input playback clocks. The output of the serial-to-parallel converter 22 is transmitted to a so-called barrel shifter (barrel rotation circuit) 25 and a window detector 24. The input signal to the window detector 24 is the 12-bit signal from the 16-bit signal from the converter 22.

The playback clocks supplied via the input terminal 21 are supplied to a frequency divided 23. The clock signals frequency divided by sixteen by the frequency divider 23 are supplied to the window detector 24, the barrel shifter 25 and to a ROM 26.

The window detector 24 has the function of detecting a pattern indicating the boundary between the code blocks produced upon 8-16 conversion. For effecting this detection, the window detector 24 converts the phase difference between the pattern indicating the detected boundary and the clock divided in frequency by sixteen at the frequency divider 23, in terms of a deviation from the edge, into 4-bit digital signals, which are then supplied to the barrel shifter 25.

The barrel shifter 25 phase-shifts the 16-bit output signals from the converter 22 in accordance with the 4-bit digital code data supplied from the window detector 24. The phase-adjusted 16-bit signals are supplied to the ROM 26.

The ROM 30 is operated by playback clock signals divided in frequency by sixteen from frequency divider 23 to output 8-bit output data corresponding to the supplied 16-bit signals at an output terminal 27.

The ROM 30 also outputs synchronization detection bits and error detection bits at output terminals 28 and 29, respectively.

With the above arrangement, decoding may be effected in accordance with the present 8-16 conversion system.

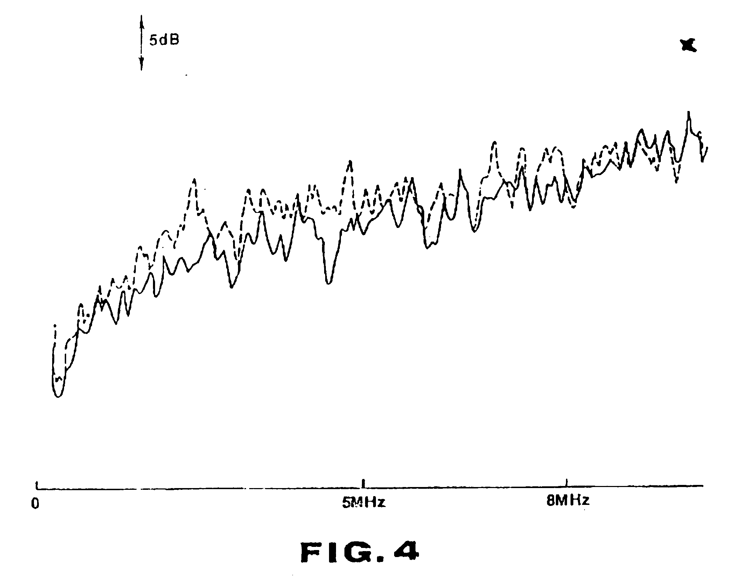

Figure 4 shows the results of analyses by a spectrum analyzer of frequency characteristics of the present 8-16 conversion system and the M code.

As shown in Figure 4, the level of the spectrum shown by the frequency characteristics of the present 8-16 conversion system is smaller than the level of the spectrum shown by the frequency characteristics of the M code, with a frequency of about 5MHz as a boundary. Thus it is shown that low frequency components may be suppressed by diminishing the maximum length between transitions T_{MAX}.

Table 6 shows parameters characteristic of various conversion systems.

**TABLE 6**

| | | Novel 8 to 16 Conversion | M Code | 8 to 14 Conversion |
|---|---|---|---|---|
| Minimum Length Between Transitions | T_{MIN} | 1.0T | 1.0T | 1.14T |
| Maximum Length Between Transitions | T_{MAX} | 2.5T | 3.0T | 4.0T |
| Window Margin | T_{w} | 0.5T | 0.5T | 0.56T |
| Level Sum Value | \|DSV\| | ≦3.0 | ≦3.0 | ≦11.0 |
| Level Sum Value | \|CDS\| | ≦4.0 | - | ≦6.0 |
| Number of Coded Data | | 918/2¹⁸ | - | 667/2¹⁴ |

It is seen from Table 6 that, with the present 8-16 conversion system, the minimum length between transitions T_{MIN}, the window margin T_{w} and the DSV are maintained at the same level as those of the M code, while the maximum length between transitions T_{MAX} may be less than that with the M code. The result is that the low frequency components may be suppressed more extensively than in the case of modulation by the M code.

With the present 8-16 conversion system, because of the smaller content of the low frequency components than in the M code, it is possible to diminish cross-talk between adjacent tracks during recording to improve the S/N ratio of the eye pattern.

On the other hand, even if the shortest wavelength employed for recording is about the same as that in the M code, the maximum length between transitions may be as small as 2.5T to facilitate clock locking by the PLL system on the reproducing side.

With the present 8-16 conversion system, the rate of erasure during overwriting may be improved by improved spectral concentration. In addition, the hardware required may be reduced by arraying the modulation code carrying tables suitably in the ROM.

From the foregoing it is seen that embodiments of the present invention provide digital modulation systems in which a string of input data is divided at an interval of 8 bits and the resulting 8-bit data are converted into 16-bit digital modulation code data, wherein the 16-bit digital modulation code data satisfy the conditions that the number of consecutive "0"s or "1"s is two or more between the 2nd bit and the 15th bit, the number of consecutive "0"s or "1"s between the 1st bit and the 16th bit is five or less, the number of consecutive "0"s or "1"s between the 13th bit and the 16th bit is four or less, the absolute value of the sum of the 16 bits of the modulation code, used for calculating a digital sum value (DSV) in which "1" and "0" of the bits in the modulation code are set to "+1" and "-1" and summed together, is four or less; and the absolute value of the sum from the leading bit to an arbitrarily selected kth bit in the modulation code, or CDS(k), is five or less, and wherein the number of consecutive "0"s or "1"s in any part of digital data produced upon consecutively transmitting or recording 16-bit digital modulation code data satisfying the above conditions is not less than two and not more than five, the 16-bit digital modulation code data is substantially dc-free and the absolute value of the DSV is not more than three. With the present modulation system, an error rate more favourable than that with the known M code may be achieved for realizing short wavelength recording for narrower tracks for high density recording on, for example, a digital tape recorder. The erasure rate during overwriting may be improved because the data is divided at an interval of 8 bits, and the resulting 8-bit data are converted into 16-bit digital modulation code data, wherein the 16-bit digital modulation code data satisfy the conditions that the number of consecutive "0"s or "1"s is two or mote between the 2nd bit and the 15th bit, the number of consecutive "0"s or "1"s between the 1st bit and the 16th bit is five or less, the number of consecutive "0"s or "1"s between the 13th bit and the 16th bit is four or less, the absolute value of the sum of the 16 bits of the modulation code, used for calculating a digital sum value (DSV) in which "1" and "0" of the bits in the modulation code are set to "+1" and "-1" and summed together, is four or less; and the absolute value of the sum from the leading bit to an arbitrarily selected kth bit in the modulation code, or the CDS(k), is five or less, and wherein the number of consecutive "0"s or "1"s in any part of digital data produced upon consecutively transmitting or recording 16-bit digital modulation code data satisfying the above conditions is not less than two and not more than five, the 16-bit digital modulation code data is substantially dc-free and the absolute value of the DSV is not more than three. With the present modulation system, an error rate more favourable than that with the M code may be achieved for realizing a short wavelength recording for narrower tracks for high density recording on, for example, a digital tape recorder. The erasure rate during overwriting may be improved because of the higher degree of spectral concentration.

The quantity of hardware may also be reduced by selection of the arraying of modulation code tables within the ROM.

## Claims

1. A digital modulation method for converting 8-bit data of a binary system, wherein each bit indicates one of two binary values "1" or "0", into binary 16-bit data of the same binary system, said modulation method comprising:
a first step of sequentially separating 8-bit data from an input data string;
a second step of forming a number of different 16-bit data of from 1st to 16th bits, satisfying the following conditions (1) to (6), for each of said 8-bit data;
(1) the number of consecutive "0"s or "1"s from the 2nd to the 15th bits is two or more;
(2) the number of consecutive "0"s or "1"s from the 1st to the 16th bits is five or less;
(3) the number of consecutive "0"s or "1"s from the 13th to the 16th bits is four or more;
(4) the absolute value of the code word digital sum CDS, obtained upon summing scores "+1" and "-1" for said binary values of "1" and "0", respectively, for the 1st to 16th bits, is four or less;
(5) the absolute value of the code word digital sum CDS(k), obtained upon summing scores "+1" and "-1" for said binary values of "1" and "0", respectively, for the 1st to kth bits, where 1≦k≦16, is five or less; and
(6) when the 16-bit data are converted into serial data which are then coupled together and outputted, the number of consecutive "0"s and "1"s in any part of the outputted serial data is not less than two and not more than five, and the value of DSV, obtained as the sum of scores "+1" and "-1", for said binary values of "1" and "0", respectively, is not more than three; and
a third step of converting the 16-bit data from the second step into serial data and coupling the serial 16-bit data for outputting as coupled modulated digital data.

2. A method according to claim 1 wherein said second step comprises a sub-step of selecting one of first, second, third, fourth, fifth and sixth tables each containing data:
said data being so defined that if, among 16-bit data satisfying the above conditions (1) to (5), data satisfying logical formulae (i) AND ((ii) OR (iii) OR (iv)) below are of a data group A, and, among 16-bit data satisfying the above conditions (1) to (6), data satisfying a logical formula (v) OR (vi) OR (vii) OR (viii) OR (ix) OR (x) below are of a data group B;
(i) the number of consecutive "0"s or "1"s from the first bit is not more than four and the absolute value of CDS(k) is not more than three;
(ii) CDS=0;
(iii) CDS=-2 and the 1st, 15th and 16th bits are all "0";
(iv) CDS=+2 and the 1st bit is "0" and the 15th and 16th bits are "0";
(v) CDS=0, CDS(k) is not less than -5, the 1st and 2nd bits are "0" while the 15th and 16th bits are "1";
(vi) CDS=0, CDS(k) is not less than -5 and not more than 1, the 1st bit is "1", the 2nd bit is "1" while the 15th and 16th bits are "1";
(vii) CDS=-2, CDS(k) is not less than -5 and not more than 1, and the 1st and 2nd bits are "0";
(viii) CDS=-2, CDS(k) is not less than -5 and not more than 1, and the 1st bit is "1" and 2nd bit is "0";
(ix) CDS=-4, CDS(k) is not less than -5 and not more than 1, and the 1st, 2nd, 15th and 16th bits are "0";
(x) CDS=-4, CDS(k) is not less than -5 and not more than 1, and the 1st and 2nd bits are "0" while the 15th and 16th bits are "0";
data stored in said first to sixth tables are defined so that:
data stored in said first table are those among the data of the group A in which the 1st and 2nd data are both "0", the 15th bit is "0" and the 16th bit is "1", and data appended to these data for indicating the states of these data;
data stored in said second table are complemented data of the data stored in said first table;
data stored in said third table are those among the data of the group A in which the 1st and 2nd data are both "0", the 15th bit is "1" and the 16th bit is "0", and data appended to these data for indicating the states of these data;
data stored in said fourth table are complemented data of the data stored in said third table;
data stored in said fifth table are those among the data of the group A in which the 1st and 2nd data are both "0", the 15th bit is "1" and the 16th bit is "0", and data appended to these data for indicating the states of these data; and
data stored in said sixth table are complemented data of the data stored in said fifth table;
in said selecting sub-step, one of the first to sixth tables is selected, on the basis of data indicating the 15th and 16th bits and the data indicating the states of the data in said first to sixth tables, and the 18-bit data which will satisfy the conditions (1) to (5) in association with the 8-bit data are selected in the table selected in said selecting sub-step, in such a manner as to form data satisfying said condition (6).

3. A method according to claim 2 wherein data indicating the states of the data indicate the value of the DSV of the data.

4. Apparatus for digital modulation for converting 8-bit data of a binary system, wherein each bit indicates one of two binary values of "1" or "0", into binary 16-bit data of the same binary system, the apparatus comprising:
first means for sequentially separating 8-bit data from an input data string;
second means for forming a number of different 16-bit data of from 1st to 16th bits, satisfying the following conditions (1) to (6), for each of said 8-bit data:
(1) the number of consecutive "0"s or "1"s from the 2nd to the 15th bits is two or more;
(2) the number of consecutive "0"s or "1"s from the 1st to the 16th bits is five or less;
(3) the number of consecutive "0"s or "1"s from the 13th to the 16th bits is four or more;
(4) the absolute value of the code word digital sum CDS, obtained upon summing scores "+1" and "-1" for said binary values of "1" and "0", respectively, for the 1st to 16th bits, is four or less;
(5) the absolute value of the code word digital sum CDS(k), obtained upon summing scores "+1" and "-1" for said binary values of "1" and "0", respectively, for the 1st to kth bits, where 1≤k≤16, is five or less; and
(6) when the 16-bit data are converted into serial data which are then coupled together and outputted, the numbers of consecutive "0"s and "1"s in any part of the outputted serial data is not less than two and not more than five, and the value of DSV, obtained as the sum of scores "+1" and "-1", for said binary values of "1" and "0", respectively, is not more than three; and
third means for converting the 16-bit data from the second step into serial data and coupling the serial 16-bit data for outputted as coupled modulated digital data.

5. Apparatus according to claim 4 wherein said second means (14) comprises first, second, third, fourth, fifth and sixth tables, each containing data, and means for selecting one of these tables; said data being so defined that if, among 16-bit data satisfying the above conditions (1) to (5), data satisfying logical formulae (1) AND ((ii) OR (iii) OR (iv)) below are of a data group A, and, among 16-bit data satisfying the above conditions (1) to (5), data satisfying a logical formula (v) OR (vi) OR (vii) OR (viii) OR (ix) OR (x) below are of a data group B,
(i) the number of consecutive "0"s or "1"s from the first bit is not more than four and the absolute value of CDS(k) is not more than three;
(ii) CDS=0;
(iii) CDS=-2 and the 1st, 15th and 16th bits are all "0";
(iv) CDS=+2 and the 1st bit is "0" and the 15th and 16th bits are "0";
(v) CDS=0, CDS(k) is not less than -5, the 1st and 2nd bits are "0" white the 15th and 16th bits are "1";
(vi) CDS=0, CDS(k) is not less than -5 and not more than 1, the 1st bit is "1", the 2nd bit is "1" while the 15th and 16th bits are "1";
(vii) CDS=-2, CDS(k) is not less than -5 and not more than 1, and the 1st and 2nd bits are "0";
(viii) CDS=-2, CDS(k) is not less than -5 and not more than 1, and the 1st bit is "1" and 2nd bit is "0";
(ix) CDS=-4, CDS(k) is not less than -5 and not more than 1, and the 1st, 2nd, 15th and 16th bits are "0";
(x) CDS=-4, CDS(k) is not less than -5 and not more than 1, and the 1st and 2nd bits are "0" while the 15th and 16th bits are "0";
data stored in said first to sixth tales are defined so that:
data stored in said first table are those among the data of the group A in which the 1st and 2nd data are both "0", the 15th bit is "0" and the 16th bit is "1", and data appended to these data for indicating the states of these data;
data stored in said second table are complemented data of the data stored in said first table;
data stored in said third table are those among the data of the group A in which the 1st and 2nd data are both "0", the 15th bit is "1" and the 16th bit is "0", and data appended to these data for indicating the states of these data;
data stored in said fourth table are complemented data of the data stored in said third table;
data stored in said fifth table are those among the data of the group A in which the 1st and 2nd data are both "0", the 15th bit is "1" and the 16th bit is "0", and data appended to these data for indicating the states of these data; and
data stored in said sixth table are complemented data of the data stored in said fifth table;
in said selecting sub-step, one of the first to sixth tables is selected, on the basis of data indicating the 15th and 16th bits and the data indicating the states of the data in said first to sixth tables, and the 18-bit data which will satisfy the conditions (1) to (5) are selected in association with the 8-bit data in the table selected in said selecting sub-step, in such a manner as to form data satisfying said condition (6).

6. Apparatus according to claim 5 wherein data indicating the states of said data indicate the value of DSV of said data.

## Patentansprüche

1. Digitales Modulationsverfahren zur Umwandlung von 8-Bit-Daten eines Binärsystems, in dem jedes Bit einen von zwei Binärwerten "1" oder "0" bezeichnet, in binäre 16-Bit-Daten desselben Binärsystems,
wobei das Modulationsverfahren aufweist:
einen ersten Verfahrensschritt zum sequentiellen Abtrennen von 8-Bit-Daten aus einem Eingangsdatenstrom
einen zweiten Verfahrensschritt zum Bilden einer Anzahl von unterschiedlichen, die folgenden Bedingungen (1) bis (6) erfüllenden 16-Bit-Daten mit einem 1. bis 16. Bit für jede der genannten 8-Bit-Daten:
(1) die Anzahl von aufeinanderfolgenden Werten "0" oder "1" vom 2. bis zum 15. Bit beträgt zwei oder mehr,
(2) die Anzahl von aufeinanderfolgenden Werten "0" oder "1" vom 1. bis zum 16. Bit beträgt fünf oder weniger,
(3) die Anzahl von aufeinanderfolgenden Werten "0" oder "1" vom 13. bis zum 16. Bit beträgt vier oder mehr,
(4) der Absolutwert der digitalen Kodewortsumme CDS, die gewonnen wird beim Summieren von Zahlenwerten "+1" und "-1" für die genannten Binärwerte "1" bzw. "0" für das 1. bis 16. Bit, beträgt vier oder weniger,
(5) der Absolutwert der digitalen Kodewortsumme CDS(k), die gewonnen wird beim Summieren von Zahlenwerten "+1" und "-1" für die genannten Binärwerte "1" bzw. "0" für das 1. bis k-te Bit, mit 1≤k≤16, beträgt fünf oder weniger,
(6) wenn die 16-Bit-Daten in serielle Daten umgewandelt sind, die dann miteinander verbunden und ausgegeben werden, ist die Anzahl aufeinanderfolgender Werte "1" und "0" in irgendeinem Teil der ausgegebenen seriellen Daten nicht kleiner als zwei und nicht größer als fünf, und der als Summe von Zahlenwerten "+1" und "-1" für die genannten Binärwerte "1" bzw. "0" gewonnene Wert DSV ist nicht größer als drei,
und einen dritten Verfahrensschritt zum Umwandeln der 16-Bit-Daten aus dem zweiten Verfahrensschritt in serielle Daten und zum Verbinden der seriellen 16-Bit-Daten für ihre Ausgabe als verbundene modulierte digitale Daten.

2. Verfahren nach Anspruch 1,
bei dem der zweite Verfahrensschritt einen Unterschritt umfaßt, in dem eine Tabelle ausgewählt wird aus einer ersten, einer zweiten, einer dritten, einer vierten, einer fünften
und einer sechsten Tabelle, die jeweils Daten enthalten,
wobei die Daten so definiert sind, daß von den 16-Bit-Daten, die die obigen Bedingungen (1) bis (5) erfüllen, diejenigen Daten, die die unten angebenen logischen Gleichungen (i) UND [(ii) ODER (iii) ODER (iv)] befriedigen, einer Datengruppe A angehören, und von den 16-Bit-Daten, die die obigen Bedingungen (1) bis (6) erfüllen, diejenigen Daten, die die unten angebene logische Gleichung (v) ODER (vi) ODER (vii) ODER (viii) ODER (ix) ODER (x) befriedigen, einer Datengruppe B angehören:
(i) die Anzahl von aufeinanderfolgenden Werten "0" oder "1" vom 1. Bit an ist nicht größer als vier und der Absolutwert von CDS(k) ist nicht größer als drei,
(ii) CDS = 0,
(iii) CDS = -2 und das 1., 15. und 16. Bit sind alle "0",
(iv) CDS = +2, das 1. Bit ist "0" und das 15. und 16. Bit sind "0",
(v) CDS = 0, CDS(k) ist nicht kleiner als -5 und das 1. und das 2. Bit sind "0" , während das 15. und das 16. Bit "1" sind,
(vi) CDS = 0, CDS(k) ist nicht kleiner als -5 und nicht größer als 1, das 1. Bit ist "1", das 2. Bit ist "1", während das 15. und das 16. Bit "1" sind,
(vii) CDS = -2, CDS(k) ist nicht kleiner als -5 und nicht größer als 1 und das 1. und das 2. Bit sind "0",
(viii) CDS = -2, CDS(k) ist nicht kleiner als -5 und nicht größer als 1, das 1. Bit ist "1" und das 2. Bit ist "0" ,
(ix) CDS = -4, CDS(k) ist nicht kleiner als -5 und nicht größer als 1, das 1., 2., 15. und 16 Bit sind "0",
(x) CDS = -4, CDS(k) ist nicht kleiner als -5 und nicht größer als 1 und das 1. und das 2. Bit sind "0", während das 15. und das 16. Bit "1" sind,
wobei die in der ersten bis sechsten Tabelle gespeicherten Daten folgendermaßen definiert sind:
- die in der ersten Tabelle gespeicherten Daten sind diejenigen Daten aus der Datengruppe A, in denen das 1. und 2. Bit beide "0" sind, das 15. Bit "0" ist und das 16. Bit "1" ist, sowie diesen Daten angehängte Daten zur Kennzeichnung der Zustände dieser Daten,
- die in der zweiten Tabelle gespeicherten Daten sind Daten, die zu den in der ersten Tabelle gespeicherten Daten komplementär sind,
- die in der dritten Tabelle gespeicherten Daten sind diejenigen Daten aus der Datengruppe A, in denen das 1. und 2. Bit beide "0" sind, das 15. Bit "1" ist und das 16. Bit "0" ist, sowie diesen Daten angehängte Daten zur Kennzeichnung der Zustände dieser Daten,
- die in der vierten Tabelle gespeicherten Daten sind Daten, die zu den in der dritten Tabelle gespeicherten Daten komplementär sind,
- die in der fünften Tabelle gespeicherten Daten sind diejenigen Daten aus der Datengruppe A, in denen das 1. und 2. Bit beide "0" sind, das 15. Bit "1" ist und das 16. Bit "0" ist, sowie diesen Daten angehängte Daten zur Kennzeichnung der Zustände dieser Daten,
- die in der sechsten Tabelle gespeicherten Daten sind Daten, die zu den in der fünften Tabelle gespeicherten Daten komplementär sind,
wobei in dem Auswahl-Unterschritt eine Tabelle aus der ersten bis sechsten Tabelle auf der Basis der Daten ausgewählt wird, die das 15. und 16. Bit kennzeichnen, sowie auf der Basis der Daten, die die Zustände der Daten in der ersten bis sechsten Tabelle kennzeichnen, und wobei die 18-Bit-Daten, die die Bedingungen (1) bis (5) erfüllen, in Verbindung mit den 8-Bit-Daten in der in dem Auswahl-Unterschritt ausgewählten Tabelle so ausgewählt werden, daß Daten gebildet werden, die die Bedingung (6) erfüllen.

3. Verfahren nach Anspruch 2, bei dem Daten, die die Zustände der Daten anzeigen, den DSV-Wert der Daten anzeigen.

4. Gerät zur digitalen Modulation für die zur Umwandlung von 8-Bit-Daten eines Binärsystems, in dem jedes Bit einen von zwei Binärwerten ""1" oder "0" bezeichnet, in binäre 16-Bit-Daten desselben Binärsystems, wobei das Gerät aufweist:
erste Mittel zum sequentiellen Abtrennen von 8-Bit-Daten aus einem Eingangsdatenstrom,
zweite Mittel zum Bilden einer Anzahl von unterschiedlichen, die folgenden Bedingungen (1) bis (6) erfüllenden 16-Bit-Daten mit einem 1. bis 16. Bit für jede der genannten 8-Bit-Daten:
(1) die Anzahl von aufeinanderfolgenden Werten "0" oder "1" vom 2. bis zum 15. Bit beträgt zwei oder mehr,
(2) die Anzahl von aufeinanderfolgenden Werten "0" oder "1" vom 1. bis zum 16. Bit beträgt fünf oder weniger,
(3) die Anzahl von aufeinanderfolgenden Werten "0" oder "1" vom 13. bis zum 16. Bit beträgt vier oder mehr,
(4) der Absolutwert der digitalen Kodewortsumme CDS, die gewonnen wird beim Summieren von Zahlenwerten "+1" und "-1" für die genannten Binärwerte "1" bzw. "0" für das 1. bis 16. Bit, beträgt vier oder weniger,
(5) der Absolutwert der digitalen Kodewortsumme CDS(k), die gewonnen wird beim Summieren von Zahlenwerten "+1" und "-1" für die genannten Binärwerte "1" bzw. "0" für das 1. bis k-te Bit, mit 1≤k≤16, beträgt fünf oder weniger,
(6) wenn die 16-Bit-Daten in serielle Daten umgewandelt sind, die dann miteinander verbunden und ausgegeben werden, ist die Anzahl aufeinanderfolgender Werte "1" und "0" in irgendeinem Teil der ausgegebenen seriellen Daten nicht kleiner als zwei und nicht größer als fünf, und der als Summe von Zahlenwerten "+1" und "-1" für die genannten Binärwerte "1" bzw. "0" gewonnene Wert DSV ist nicht größer als drei,
und dritte Mittel zum Umwandeln der 16-Bit-Daten aus dem zweiten Verfahrensschritt in serielle Daten und zum Verbinden der seriellen 16-Bit-Daten für ihre Ausgabe als verbundene modulierte digitale Daten.

5. Gerät nach Anspruch 4,
bei dem die zweiten Mittel eine erste, eine zweite, eine dritte, eine vierte, eine fünfte und eine sechste Tabelle umfassen, die jeweils Daten enthalten, sowie Mittel zum Auswählen einer dieser Tabellen,
wobei diese Daten so definiert sind, daß für den Fall, daß von den 16-Bit-Daten, die die obigen Bedingungen (1) bis (5) erfüllen, diejenigen Daten, die die unten angebenen logischen Gleichungen (i) UND [(ii) ODER (iii) ODER (iv)] befriedigen, einer Datengruppe A angehören, und von den 16-Bit-Daten, die die obigen Bedingungen (1) bis (6) erfüllen, diejenigen Daten, die die unten angebene logische Gleichungen (v) ODER (vi) ODER (vii) ODER (viii) ODER (ix) ODER (x) befriedigen, einer Datengruppe B angehören:
(i) die Anzahl von aufeinanderfolgenden Werten "0" oder "1" vom 1. Bit an ist nicht größer als vier und der Absolutwert von CDS(k) ist nicht größer als drei,
(ii) CDS = 0,
(iii) CDS = -2 und das 1., 15. und 16. Bit sind alle "0" ,
(iv) CDS = +2, das 1. Bit ist "0" und das 15. und 16. Bit sind "0" ,
(v) CDS = 0, CDS(k) ist nicht kleiner als -5 und das 1. und das 2. Bit sind "0", während das 15. und das 16. Bit "1" sind,
(vi) CDS = 0, CDS(k) ist nicht kleiner als -5 und nicht größer als 1, das 1. Bit ist "1", das 2. Bit ist "1", während das 15. und das 16. Bit "1" sind,
(vii) CDS = -2, CDS(k) ist nicht kleiner als -5 und nicht größer als 1 und das 1. und das 2. Bit sind "0",
(viii) CDS = -2, CDS(k) ist nicht kleiner als -5 und nicht größer als 1, das 1. Bit ist "1" und das 2. Bit ist "0",
(ix) CDS = -4, CDS(k) ist nicht kleiner als -5 und nicht größer als 1, das 1., 2., 15. und 16 Bit sind "0",
(x) CDS = -4, CDS(k) ist nicht kleiner als -5 und nicht größer als 1 und das 1. und das 2. Bit sind "0", während das 15. und das 16. Bit "1" sind,
wobei die in der ersten bis sechsten Tabelle gespeicherten Daten folgendermaßen definiert sind:
- die in der ersten Tabelle gespeicherten Daten sind die Daten aus der Datengruppe A, in denen das 1. und 2. Bit beide "0" sind, das 15. Bit "0" ist und das 16. Bit "1" ist, sowie diesen Daten angehängte Daten zur Kennzeichnung der Zustände dieser Daten,
- die in der zweiten Tabelle gespeicherten Daten sind Daten, die zu den in der ersten Tabelle gespeicherten Daten komplementär sind,
- die in der dritten Tabelle gespeicherten Daten sind diejenigen Daten aus der Datengruppe A, in denen das 1. und 2. Bit beide "0" sind, das 15. Bit "1" ist und das 16. Bit "0" ist, sowie diesen Daten angehängte Daten zur Kennzeichnung der Zustände dieser Daten,
- die in der vierten Tabelle gespeicherten Daten sind Daten, die zu den in der dritten Tabelle gespeicherten Daten komplementär sind,
- die in der fünften Tabelle gespeicherten Daten sind diejenigen Daten aus der Datengruppe A, in denen das 1. und 2. Bit beide "0" sind, das 15. Bit "1" ist und das 16. Bit "0" ist, sowie diesen Daten angehängte Daten zur Kennzeichnung der Zustände dieser Daten,
- die in der sechsten Tabelle gespeicherten Daten sind Daten, die zu den in der fünften Tabelle gespeicherten Daten komplementär sind,
wobei in dem Auswahl-Unterschritt eine Tabelle aus der ersten bis sechsten Tabelle auf der Basis der Daten ausgewählt wird, die das 15. und 16. Bit kennzeichnen, sowie auf der Basis der Daten, die die Zustände der Daten in der ersten bis sechsten Tabelle kennzeichnen, und wobei die 18-Bit-Daten, die die Bedingungen (1) bis (5) erfüllen, in Verbindung mit den 8-Bit-Daten in der in dem Auswahl-Unterschritt ausgewählten Tabelle so ausgewählt werden, daß Daten gebildet werden, die die Bedingung (6) erfüllen.

6. Gerät nach Anspruch 5, bei dem Daten, die die Zustände der Daten anzeigen, den DSV-Wert der Daten anzeigen.

## Revendications

1. Un procédé de modulation numérique pour convertir des données à 8 bits d'un système binaire, dans lequel chaque bit indique l'une de deux valeurs binaires "1" ou "0", en données binaires à 16 bits du même système binaire, ce système de modulation comprenant :
une première étape consistant à séparer séquentiellement des données à 8 bits d'un train de données d'entrée ;
une seconde étape consistant à former un certain nombre de données à 16 bits différentes, allant d'un 1-ier bit à un 16-ième bit, satisfaisant les conditions (1) à (6) suivantes, pour chacune des données à 8 bits :
(1) le nombre de "0" ou de "1" consécutifs depuis le 2-ième bit jusqu'au 15-ième bit est de deux ou plus ;
(2) le nombre de "0" ou de "1" consécutifs depuis le 1-ier bit jusqu'au 16-ième bit est de cinq ou moins ;
(3) le nombre de "0" ou de "1" consécutifs depuis le 13-ième bit jusqu'au 16-ième bit est de quatre ou plus ;
(4) la valeur absolue de la somme numérique de mot de code, CDS, qui est obtenue en faisant la somme de scores de "+1" et "-1" pour les valeurs binaires précitées de "1" et "0", respectivement, pour les bits allant du 1-ier bit au 16-ième bit, est de quatre ou moins ;
(5) la valeur absolue de la somme numérique de mot de code CDS (k), obtenue en faisant la somme de scores "+1" et "-1" pour les valeurs binaires précitées de "1" et "0", respectivement, pour les bits allant du 1-ier bit au k-ième bit, avec 1≤k≤16, est de cinq ou moins ; et
(6) lorsque les données à 16 bits sont converties en données série qui sont ensuite couplées ensemble et émises, le nombre de "0" et de "1" consécutifs dans une partie quelconque des données série émises n'est pas inférieur à deux et n'est pas supérieur à cinq, et la valeur de DSV obtenue sous la forme de la somme de scores de "+1" et "-1", pour les valeurs binaires précitées de "1" et "0", respectivement, n'est pas supérieure à trois ; et
une troisième étape consistant à convertir les données à 16 bits qui proviennent de la seconde étape en données série et à coupler les données à 16 bits série pour les émettre sous la forme de données numériques modulées couplées.

2. Un procédé selon la revendication 1, dans lequel la seconde étape comprend une sous-étape qui consiste à sélectionner une table parmi des première, seconde, troisième, quatrième, cinquième et sixième tables, contenant chacune des données ;
ces données étant définies de façon que si, parmi des données à 16 bits satisfaisant les conditions (1) à (5) ci-dessus des données satisfaisant des formules logiques (I) ET ((II) OU (III) OU (IV)) ci-dessous appartiennent à un groupe de données A, et, parmi des données à 16 bits satisfaisant les conditions (1) à (6) ci-dessus des données satisfaisant une formule logique (V) OU (VI) OU (VII) OU (VIII) OU (IX) OU (X) ci-dessous appartiennent à un groupe de données B ;
(I) le nombre de "0" ou de "1" consécutifs à partir du premier bit n'est pas supérieur à quatre et la valeur absolue de CDS(k) n'est pas supérieure à trois ;
(II) CDS = 0;
(III) CDS = - 2 et les 1-ier, 15-ième et 16-ième bits ont tous la valeur "0" ;
(IV) CDS = + 2 et le 1-ier bit a la valeur "0" et les 15-ième et 16-ième bits ont la valeur "0" ;
(V) CDS = 0, CDS(k) n'est pas inférieur à - 5, les 1-ier et 2-ième bits ont la valeur "0", tandis que les 15-ième et 16-ième bits ont la valeur "1" ;
(VI) CDS = 0, CDS(k) n'est pas inférieur à - 5 et n'est pas supérieur à 1, le 1-ier bit a la valeur "1", le 2-ième bit a la valeur "1", tandis que les 15-ième et 16-ième bits ont la valeur "1";
(VII) CDS = - 2, CDS(k) n'est pas inférieur à - 5 et n'est pas supérieur à 1, et les 1-ier et 2-ième bits ont la valeur "0" ;
(VIII) CDS = - 2, CDS(k) n'est pas inférieur à - 5 et n'est pas supérieur à 1, et le 1-ier bit a la valeur "1" et le 2-ième bit a la valeur "0" ;
(IX) CDS = - 4, CDS(k) n'est pas inférieur à - 5 et n'est pas supérieur à 1, et les 1-ier, 2-ième, 15-ième et 16-ième bits ont la valeur "0" ;
(X) CDS = - 4, CDS(k) n'est pas inférieur à - 5 et n'est pas supérieur à 1, et les 1-ier et 2-ième bits ont la valeur "0", tandis que les 15-ième et 16-ième bits ont la valeur "0" ;
les données enregistrées dans les première à sixième tables sont définies de façon que :
les données enregistrées dans la première table sont celles parmi les données du groupe A dans lesquelles les 1-ière et 2-ième données ont toutes deux la valeur "0", le 15-ième bit a la valeur "0" et le 16-ième bit a la valeur "1", et des données annexées à ces données pour indiquer l'état de ces données ;
les données enregistrées dans la seconde table sont des données complémentées par rapport aux données enregistrées dans la première table ;
les données enregistrées dans la troisième table sont celles, parmi les données du groupe A, dans lesquelles les 1-ière et 2-ième données ont toutes deux la valeur "0", le 15-ième bit a la valeur "1" et le 16-ième bit a la valeur "0", et des données annexées à ces données pour indiquer les états de ces données ;
les données enregistrées dans la quatrième table sont des données complémentées par rapport aux données enregistrées dans la troisième table ;
les données enregistrées dans la cinquième table sont celles, parmi les données du groupe A, dans lesquelles les 1-ière et 2-ième données ont toutes deux la valeur "0", le 15-ième bit a la valeur "1" et le 16-ième bit a la valeur "0", et des données annexées à ces données pour indiquer les états de ces données ; et
les données enregistrées dans la sixième table sont des données complémentées par rapport aux données enregistrées dans la cinquième table ;
dans la sous-étape de sélection, l'une des première à sixième tables est sélectionnée, sur la base de données indiquant les 15-ième et 16-ième bits et des données indiquant les états des données dans les première à sixième tables, et les données à 18 bits qui satisfont les conditions (1) à (5), en association avec les données à 8 bits, sont sélectionnées dans la table sélectionnée dans la sous-étape de sélection, de manière à former des données satisfaisant la condition (6).

3. Un procédé selon la revendication 2, dans lequel des données indiquant les états des données indiquent la valeur de DSV (valeur de somme numérique) des données.

4. Dispositif de modulation numérique destiné à convertir des données à 8 bits d'un système binaire, dans lequel chaque bit indique l'une de deux valeurs binaires de "1" ou "0", en données binaires à 16 bits du même système binaire, le dispositif comprenant :
des premiers moyens pour séparer séquentiellement des données à 8 bits d'une chaîne de données d'entrée ;
des seconds moyens pour former un certain nombre de données à 16 bits, différentes, allant d'un 1-ier bit à un 16-ième bit, satisfaisant les conditions (1) à (6) suivantes, pour chacune des données à 8 bits :
(1) le nombre de "0" ou de "1" consécutifs depuis le 2-ième bit jusqu'au 15-ième bit est de deux ou plus ;
(2) le nombre de "0" ou de "1" consécutifs depuis le 1-ier bit jusqu'au 16-ième bit est de cinq ou moins ;
(3) le nombre de "0" ou de "1" consécutifs depuis le 13-ième bit jusqu'au 16-ième bit est de quatre ou plus ;
(4) la valeur absolue de la somme numérique de mot de code, CDS, qui est obtenue en faisant la somme de scores de "+1" et "-1" pour les valeurs binaires précitées de "1" et "0", respectivement, pour les bits allant du 1-ier bit au 16-ième bit, est de quatre ou moins ;
(5) la valeur absolue de la somme numérique de mot de code CDS (k), obtenue en faisant la somme de scores "+1" et "-1" pour les valeurs binaires précitées de "1" et "0", respectivement, pour les bits allant du 1-ier bit au k-ième bit, avec 1≤k≤16, est de cinq ou moins ; et
(6) lorsque les données à 16 bits sont converties en données série qui sont ensuite couplées ensemble et émises, le nombre de "0" et de "1" consécutifs dans une partie quelconque des données série émises n'est pas inférieur à deux et n'est pas supérieur à cinq, et la valeur de DSV obtenue sous la forme de la somme de scores de "+1" et "-1", pour les valeurs binaires précitées de "1" et "0", respectivement, n'est pas supérieure à trois ; et
des troisièmes moyens pour convertir les données à 16 bits provenant des seconds moyens en données série pour coupler les données à 16 bits série de façon à les émettre sous la forme de données numériques modulées couplées.

5. Dispositif selon la revendication 4, dans lequel les seconds moyens (14) comprennent des première, seconde, troisième, quatrième, cinquième et sixième tables, contenant chacune des données, et des moyens pour sélectionner l'une de ces tables ;
ces données étant définies de façon que si, parmi des données à 16 bits satisfaisant les conditions (1) à (5) ci-dessus, des données satisfaisant des formules logiques (I) ET ((II) OU (III) OU (IV)) ci-dessous appartiennent à un groupe de données A, et, parmi des données à 16 bits satisfaisant les conditions (1) à (5) ci-dessus, des données satisfaisant une formule logique (V) OU (VI) OU (VII) OU (VIII) OU (IX) OU (X) ci-dessous appartiennent à un groupe de données B ;
(I) le nombre de "0" ou de "1" consécutifs à partir du premier bit n'est pas supérieur à quatre et la valeur absolue de CDS(k) n'est pas supérieure à trois ;
(II) CDS = 0 ;
(III) CDS = - 2 et les 1-ier, 15-ième et 16-ième bits ont tous la valeur "0" ;
(IV) CDS = + 2 et le 1-ier bit a la valeur "0" et les 15-ième et 16-ième bits ont la valeur "0" ;
(V) CDS = 0, CDS(k) n'est pas inférieur à - 5, les 1-ier et 2-ième bits ont la valeur "0", tandis que les 15-ième et 16-ième bits ont la valeur "1" ;
(VI) CDS = 0, CDS(k) n'est pas inférieur à - 5 et n'est pas supérieur à 1, le 1-ier bit a la valeur "1", le 2-ième bit a la valeur "1", tandis que les 15-ième et 16-ième bits ont la valeur "1" ;
(VII) CDS = - 2, CDS(k) n'est pas inférieur à - 5 et n'est pas supérieur à 1, et les 1-ier et 2-ième bits ont la valeur "0" ;
(VIII) CDS = - 2, CDS(k) n'est pas inférieur à - 5 et n'est pas supérieur à 1, et le 1-ier bit a la valeur "1" et le 2-ième bit a la valeur "0" ;
(IX) CDS = - 4, CDS(k) n'est pas inférieur à - 5 et n'est pas supérieur à 1, et les 1-ier, 2-ième, 15-ième et 16-ième bits ont la valeur "0" ;
(X) CDS = - 4, CDS(k) n'est pas inférieur à - 5 et n'est pas supérieur à 1, et les 1-ier et 2-ième bits ont la valeur "0", tandis que les 15-ième et 16-ième bits ont la valeur "0" ;
les données enregistrées dans les première à sixième tables sont définies de façon que :
les données enregistrées dans la première table sont celles parmi les données du groupe A dans lesquelles les 1-ière et 2-ième données ont toutes deux la valeur "0", le 15-ième bit a la valeur "0" et le 16-ième bit a la valeur "1, et des données annexées à ces données pour indiquer l'état de ces données ;
les données enregistrées dans la seconde table sont des données complémentées par rapport aux données enregistrées dans la première table ;
les données enregistrées dans la troisième table sont celles, parmi les données du groupe A, dans lesquelles les 1-ière et 2-ième données ont toutes deux la valeur "0", le 15-ième bit a la valeur "1" et le 16-ième bit a la valeur "0", et des données annexées à ces données pour indiquer les états de ces données ;
les données enregistrées dans la quatrième table sont des données complémentées par rapport aux données enregistrées dans la troisième table ;
les données enregistrées dans la cinquième table sont celles, parmi les données du groupe A, dans lesquelles les 1-ière et 2-ième données ont toutes deux la valeur "0", le 15-ième bit a la valeur "1" et le 16-ième bit a la valeur "0", et des données annexées à ces données pour indiquer les états de ces données ; et
les données enregistrées dans la sixième table sont des données complémentées par rapport aux données enregistrées dans la cinquième table ;
dans les moyens de sélection, l'une des première à sixième tables est sélectionnée, sur la base de données indiquant les 15-ième et 16-ième bits et des données indiquant les états des données dans les première à sixième tables, et les données à 18 bits qui satisfont les conditions (1) à (5) sont sélectionnées en association avec les données à 8 bits dans la table sélectionnée dans les moyens de sélection, de manière à former des données satisfaisant la condition (6).

6. Dispositif selon la revendication 5, dans lequel des données indiquant les états des données indiquent la valeur de DSV (valeur de somme numérique) des données.
